# EUROPÄISCHE PATENTSCHRIFT

(11) **EP 3 701 563 B1**
(45) Veröffentlichungstag und Bekanntmachung des Hinweises auf die Patenterteilung: **01.12.2021**
(21) Anmeldenummer: 18792862.7
(22) Anmeldetag: 09.10.2018
(51) Int. Cl.: H01L 21/322

(54) **HALBLEITERSCHEIBE AUS EINKRISTALLINEM SILIZIUM**
SEMICONDUCTOR WAFER COMPOSED OF MONOCRYSTALLINE SILICON
DISQUE SEMI-CONDUCTEUR FAIT DE SILICIUM MONOCRISTALLIN

(30) Priorität: 26.10.2017 DE 102017219255
(43) Veröffentlichungstag der Anmeldung: 02.09.2020
(73) Patentinhaber: Siltronic AG, 81677 München (DE)
(72) Erfinder: MÜLLER, Timo, 84489 Burghausen (DE); BOY, Michael, 83329 Waging am See (DE); GEHMLICH, Michael, 09600 Weißenborn (DE); SATTLER, Andreas, 83308 Trostberg (DE)
(74) Vertreter: Staudacher, Wolfgang
(86) Internationale Anmeldenummer: PCT/EP2018/077497
(87) Internationale Veröffentlichungsnummer: WO 2019/081201

(56) Entgegenhaltungen:
- EP-A1- 0 889 510
- JP-A- 2003 115 491
- US-A1- 2005 054 124
- US-A1- 2010 105 191

## Beschreibung

Gegenstand der Erfindung ist eine Halbleiterscheibe aus einkristallinem Silizium mit einer Vorderseite und mit einer Rückseite, wobei die Halbeiterscheibe eine denuded zone, die sich von der Vorderseite in Richtung der Rückseite bis zu einer bestimmten Tiefe erstreckt, aufweist und einen Bereich, der an die denuded zone angrenzt und BMD-Keime enthält.

Eine denuded zone ist ein Bereich der Halbleiterscheibe, der sich von der Vorderseite in Richtung der Rückseite über eine bestimmte Tiefe erstreckt und in dem BMDs (bulk micro defects) genannte Sauerstoffpräzipitate nicht gebildet werden. Üblicherweise ist die denuded zone als Ort vorgesehen, um elektronische Bauelemente unterzubringen.

An die denuded zone grenzt ein weiter ins Innere (bulk) der Halbleiterscheibe reichender Bereich an, in dem BMD-Keime vorhanden sind. BMD-Keime werden durch eine Wärmebehandlung zu BMDs entwickelt. BMDs wirken als sogenannte interne Getter, die insbesondere metallische Verunreinigungen binden können. Die Entwicklung von BMD-Keimen zu BMDs ist auch im Zug einer Wärmebehandlung möglich, die vornehmlich dem Aufbau von elektronischen Bauelementen in der denuded zone dient.

EP 0889510 A1 (SUMITOMO SITIX CORP [JP]) 7. Januar 1999 (1999-01-07) offenbart eine Halbleiterscheibe aus einkristallinem Silizium umfassend eine polierte Vorderseite und eine Rückseite; eine denuded zone, die sich von der polierten Vorderseite zur Rückseite bis in eine Tiefe von nicht weniger als 30 µm erstreckt; und einen Bereich, der an die denuded zone angrenzt und BMD-Keime aufweist.

Es ist bekannt, dass die Gegenwart von Leerstellen im Einkristall vorteilhaft ist, wenn vergleichsweise hohe Dichten an BMDs angestrebt werden. In der US 2002/0170631 A1 ist ein Verfahren zur Herstellung einer Halbleiterscheibe aus einkristallinem Silizium mit einer tiefen denuded zone beschrieben. Das Verfahren umfasst eine Wärmebehandlung (RTA-Behandlung, rapid thermal anneal) der Halbleiterscheibe, die ein kurzzeitiges schnelles Erhitzen und Abkühlen der Halbleiterscheibe beinhaltet. Die RTA-Behandlung soll in einer Atmosphäre durchgeführt werden, die Sauerstoff in einer Konzentration von nicht weniger als 100 ppma und nicht mehr als 10 000 ppma enthält. Darüber hinaus ist das beschriebene Verfahren so konzipiert, dass ein Konzentrationsprofil von Leerstellen entsteht, bei dem die Spitzendichte an Leerstellen in der Mitte zwischen der Vorderseite und der Rückseite der Halbleiterscheibe erreicht wird oder nahe der Mitte. Da die Konzentrationsprofile der Leerstellen, der BMD-Keime und der BMDs korrelieren, wird die Spitzendichte an BMDs ebenfalls in der Mitte oder nahe der Mitte gefunden.

Die Herstellung moderner integrierter Schaltungen mit 3D-Architektur erfordert die Bereitstellung einer denuded zone, die sich vergleichsweise tief ins Innere der Halbleiterscheibe erstreckt, und einen sich daran anschließenden Bereich mit BMD-Keimen, die sich zu BMDs entwickeln lassen, wobei der Abstand der BMDs zur denuded zone möglichst klein sein soll. Eine bekannte Prozessfolge umfasst die Silizium-Durchkontaktierung (through silicon via, TSV) und das Zurückschleifen der Halbleiterscheibe von der Rückseite aus bis weit über die Mitte der Halbleiterscheibe hinaus (M.Motoyoshi, Proceedings of the IEEE, Vol.97, No.1, January 2009). Die Nähe der BMDs zur denuded zone soll sicherstellen, dass auch in der zurückgeschliffenen Halbleiterscheibe eine ausreichende Dichte an Getterzentren vorhanden ist, insbesondere auch bereits während des Aufbaus von Strukturen elektronischer Bauelemente.

Es ist deshalb die Aufgabe der vorliegenden Erfindung, eine Halbleiterscheibe aus einkristallinem Silizium bereitzustellen, die den genannten Anforderungen besser gerecht wird.
Gelöst wird die Aufgabe durch eine Halbleiterscheibe aus einkristallinem Silizium umfassend eine polierte Vorderseite und eine Rückseite;
eine denuded zone, die sich von der polierten Vorderseite zur Rückseite bis in eine Tiefe von nicht weniger als 45 µm erstreckt; und
einen Bereich, der an die denuded zone angrenzt und BMD-Keime aufweist, die sich zu BMDs entwickeln lassen, wobei eine Dichte der BMDs im Abstand von 120 µm zur Vorderseite nicht weniger als 3 x 10⁹ cm⁻³ beträgt.

Bei der Halbleiterscheibe aus einkristallinem Silizium handelt es sich entweder um eine unbeschichtete Halbleiterscheibe oder um eine Halbleiterscheibe, die mit mindestens einer epitaktischen Schicht beschichtet ist. Ist die Halbleiterscheibe aus einkristallinem Silizium mit einer epitaktischen Schicht beschichtet, bildet die obere Oberfläche der epitaktischen Schicht die Vorderseite der Halbleiterscheibe. Die mindestens eine epitaktische Schicht hat vorzugsweise eine Dicke von nicht weniger als 1 µm und nicht mehr als 5 µm.

Gemäß einer ersten bevorzugten Ausführungsform der Erfindung ist die Halbleiterscheibe aus einkristallinem Silizium eine unbeschichtete Substratscheibe aus einkristallinem Silizium, deren denuded zone sich von der polierten Vorderseite bis in eine Tiefe von nicht weniger als 45 µm erstreckt, wobei die Halbeiterscheibe im Bereich, der an die denuded zone angrenzt BMD-Keime aufweist, nach deren Entwicklung zu BMDs die Dichte der BMDs im Abstand von 120 µm zur Vorderseite nicht weniger als 3 x 10⁹ cm⁻³ beträgt.

Gemäß einer zweiten bevorzugten Ausführungsform der Erfindung ist die Halbleiterscheibe aus einkristallinem Silizium eine Substratscheibe aus einkristallinem Silizium, die mit mindestens einer epitaktischen Schicht aus einkristallinem Silizium beschichtet ist, und deren denuded zone sich von der polierten Vorderseite der beschichteten Substratscheibe bis in eine Tiefe von nicht weniger als 45 µm erstreckt, wobei die Halbeiterscheibe im Bereich, der an die denuded zone angrenzt, BMD-Keime aufweist, nach deren Entwicklung zu BMDs die Dichte der BMDs im Abstand von 120 µm zur Vorderseite nicht weniger als 3 x 10⁹ cm⁻³ beträgt.

Die mindestens eine epitaktische Schicht hat eine Dicke von vorzugsweise nicht weniger als 1 µm und nicht mehr als 5 µm. Die Halbleiterscheibe gemäß der zweiten bevorzugten Ausführungsform der Erfindung ist vorzugsweise eine epitaktisch beschichtete Substratscheibe mit n/n⁻-Dotierung oder p/p⁻-Dotierung. Der Dotierstoff vom N-Typ ist vorzugsweise Phosphor und der Dotierstoff vom P-Typ vorzugsweise Bor.

Gemäß einer dritten Ausführungsform ist die Halbleiterscheibe aus einkristallinem Silizium eine unbeschichtete Substratscheibe aus einkristallinem Silizium, deren denuded zone sich von der polierten Vorderseite bis in eine Tiefe von nicht weniger als 30 µm erstreckt, wobei die Halbeiterscheibe im Bereich, der an die denuded zone angrenzt BMD-Keime aufweist, nach deren Entwicklung zu BMDs die Dichte der BMDs im Abstand von 120 µm zur Vorderseite nicht weniger als 2 x 10⁸ cm⁻³ beträgt. Die Herstellung einer Halbleiterscheibe gemäß der dritten Ausführungsform erfordert eine vergleichsweise geringe Anzahl an Verfahrensschritten. Die dritte Ausführungsform ist nicht erfindungsgemäß und dient lediglich der Veranschaulichung.

Eine erfindungsgemäße Halbleiterscheibe aus einkristallinem Silizium weist in einem Bereich unter der denuded zone BMD-Keime auf, die zu BMDs entwickelt werden können. Vorzugsweise nimmt die Dichte entwickelter BMDs von einer Spitzendichte zur Mittelebene der Halbleiterscheibe hin ab. Die Halbleiterscheibe aus einkristallinem Silizium kann von der Rückseite aus auf eine Restdicke zurückgeschliffen werden, wobei vorzugsweise der Bereich, in dem die Spitzendichte an BMDs entwickelt werden kann, erhalten bleibt.

In der denuded zone ist die Lebensdauer von Minoritäts-Ladungsträgern vorzugsweise durchschnittlich größer als 1000 µs.

Die Rückseite einer erfindungsgemäßen Halbleiterscheibe aus einkristallinem Silizium ist vorzugsweise mit nicht mehr als 100 Defekten größer als 0,2 µm belastet.

Die Herstellung einer Halbleiterscheibe gemäß der ersten bevorzugten Ausführungsform der Erfindung umfasst folgende Verfahrensschritte:
das Bereitstellen einer Substratscheibe aus einkristallinem Silizium;
das Polieren der Substratscheibe mittels DSP;
das Beladen eines RTA-Reaktors mit der Substratscheibe;
eine erste RTA-Behandlung der Substratscheibe bei einer Temperatur in einem Temperaturbereich von nicht weniger als 1275 °C und nicht mehr als 1295 °C für einen Zeitraum von nicht weniger als 15 s und nicht mehr als 30 s in einer Atmosphäre bestehend aus Argon und Sauerstoff mit einem Anteil an Sauerstoff von nicht weniger als 0,5 Vol-% und nicht mehr als 2 Vol-%;
das Abkühlen der Substratscheibe im Anschluss an die erste RTA-Behandlung auf eine Temperatur von nicht mehr als 800 °C, wobei eine Gaszufuhr zur Halbleiterscheibe auf 100 Vol-% Argon umgestellt wird;
eine zweite RTA-Behandlung der Halbleiterscheibe bei einer Temperatur in einem Temperaturbereich von nicht weniger als 1280 °C und nicht mehr als 1300 °C für einen Zeitraum von nicht weniger als 20 s und nicht mehr als 35 s in einer Atmosphäre bestehend aus Argon;
das Entfernen einer Oxidschicht von einer Vorderseite der Halbleiterscheibe; und
das Polieren der Vorderseite der Substratscheibe mittels CMP.

DSP (double side polishing) ist eine Politur, im Verlauf derer die Vorderseite und die Rückseite einer Substratscheibe gleichzeitig poliert werden.

CMP (chemical mechanical polishing) ist eine Politur, im Verlauf derer die Vorderseite oder die Rückseite einer Substratscheibe poliert wird.

Die Oxidschicht, die nach der ersten RTA-Behandlung auf der Substratscheibe vorhanden ist, wird von der Vorderseite der Substratscheibe entfernt, vorzugsweise indem die Substratscheibe mit wässeriger HF-Lösung behandelt wird. Die wässerige HF-Lösung enthält vorzugsweise nicht weniger als 0,5 Gew.-% HF und nicht mehr als 2 Gew.-% HF, und die Behandlung dauert vorzugsweise nicht weniger als 150 s und nicht mehr als 350 s.

Die Herstellung einer Halbleiterscheibe gemäß der zweiten bevorzugten Ausführungsform der Erfindung umfasst folgende Verfahrensschritte:
das Bereitstellen einer Substratscheibe aus einkristallinem Silizium;
das Polieren der Substratscheibe mittels DSP;
das Polieren einer Vorderseite der Substratscheibe mittels CMP;
das Abscheiden mindestens einer epitaktischen Schicht aus einkristallinem Silizium auf der Vorderseite der Substratscheibe;
das Beladen eines RTA-Reaktors mit der beschichteten Substratscheibe;
eine erste RTA-Behandlung der beschichteten Substratscheibe bei einer Temperatur in einem Temperaturbereich von nicht weniger als 1275 °C und nicht mehr als 1295 °C für einen Zeitraum von nicht weniger als 15 s und nicht mehr als 30 s in einer Atmosphäre bestehend aus Argon und Sauerstoff mit einem Anteil an Sauerstoff von nicht weniger als 0,5 Vol-% und nicht mehr als 2 Vol-%;
das Abkühlen der beschichteten Substratscheibe im Anschluss an die erste RTA-Behandlung auf eine Temperatur von nicht mehr als 800 °C, wobei eine Gaszufuhr zur Halbleiterscheibe auf 100 Vol-% Argon umgestellt wird;
eine zweite RTA-Behandlung der beschichteten Substratscheibe bei einer Temperatur in einem Temperaturbereich von nicht weniger als 1280 °C und nicht mehr als 1300 °C für einen Zeitraum von nicht weniger als 20 s und nicht mehr als 35 s in einer Atmosphäre bestehend aus Argon;
das Entfernen einer Oxidschicht von einer Vorderseite der beschichteten Substratscheibe; und
das Polieren der Vorderseite der beschichteten Substratscheibe mittels CMP.

Die Oxidschicht, die nach der ersten RTA-Behandlung auf der beschichteten Substratscheibe vorhanden ist, wird von der Vorderseite der beschichteten Substratscheibe entfernt, vorzugsweise indem die beschichtete Substratscheibe mit wässeriger HF-Lösung behandelt wird. Die wässerige HF-Lösung enthält vorzugsweise nicht weniger als 0,5 Gew.-% HF und nicht mehr als 2 Gew.-% HF, und die Behandlung dauert vorzugsweise nicht weniger als 150 s und nicht mehr als 350 s.

Die Abscheiden der mindestens einen epitaktischen Schicht auf der Substratscheibe erfolgt vorzugsweise mittels CVD (chemical vapor deposition) und vorzugsweise in einem Einzelscheiben-Reaktor, beispielsweise so, wie es in US 2010/0213168 A1 beschrieben ist. Ein bevorzugtes Abscheidegas enthält Trichlorsilan als Siliziumquelle. Die Abscheidetemperatur ist dann vorzugsweise nicht weniger als 1110 °C und nicht mehr als 1180 °C, besonders bevorzugt 1130 °C. Darüber hinaus enthält das Abscheidegas vorzugsweise einen Dotierstoff vom N-Typ oder vom P-Typ.

Die Herstellung einer Halbleiterscheibe gemäß der dritten

Ausführungsform umfasst folgende Verfahrensschritte:
das Bereitstellen einer Substratscheibe aus einkristallinem Silizium;
das Beladen eines RTA-Reaktors mit der Substratscheibe;
eine erste RTA-Behandlung der Substratscheibe bei einer Temperatur in einem Temperaturbereich von nicht weniger als 1250 °C und nicht mehr als 1310 °C für einen Zeitraum von nicht weniger als 5 s und nicht mehr als 40 s in einer Atmosphäre bestehend aus Stickstoff und Sauerstoff mit einem Anteil an Sauerstoff von nicht weniger als 0,5 Vol-% und nicht mehr als 3,0 Vol-%;
das Abkühlen der Substratscheibe im Anschluss an die erste RTA-Behandlung auf eine Temperatur von nicht mehr als 800 °C, wobei eine Gaszufuhr zur Substratscheibe auf 100 Vol-% Argon umgestellt wird;
eine zweite RTA-Behandlung der Substratscheibe bei einer Temperatur in einem Temperaturbereich von nicht weniger als 1280 °C und nicht mehr als 1300 °C für einen Zeitraum von nicht weniger als 20 s und nicht mehr als 35 s in einer Atmosphäre bestehend aus Argon;
das Polieren der Substratscheibe mittels DSP; und
das Polieren einer Vorderseite der Substratscheibe mittels CMP.

Die Oxidschicht, die nach der ersten RTA-Behandlung auf der Substratscheibe vorhanden ist, wird durch das Polieren der Substratscheibe mittels DSP von der Vorderseite der Substratscheibe entfernt. Der dabei erzielte Materialabtrag von der Vorderseite und der Rückseite der Substratscheibe beträgt vorzugsweise jeweils nicht weniger als 8 µm.

Das Bereitstellen einer Substratscheibe aus einkristallinem Silizium ist ein Schritt, der am Anfang der beschriebenen Herstellungsverfahren steht. Die Substratscheibe wird vorzugsweise von einem Einkristall aus einkristallinem Silizium geschnitten, der gemäß der CZ-Methode gezogen wurde, und weiterverarbeitet. Bei der CZ-Methode wird Silizium in einem Tiegel aus Quarz geschmolzen und der Einkristall wächst am Ende eines Keimkristalls, der in die entstandene Schmelze getaucht und angehoben wird. Das Tiegelmaterial wird durch den Kontakt mit der Schmelze teilweise gelöst und stellt auf diese Weise Sauerstoff zur Verfügung, der später zur Entwicklung von BMDs benötigt wird.

Der Einkristall aus einkristallinem Silizium hat vorzugsweise einen Durchmesser von nicht weniger als 300 mm. Die vom Einkristall geschnittene Substratscheibe besteht vorzugsweise aus N-Gebiet. N-Gebiet ist eine Bezeichnung für einkristallines Silizium, das weder Agglomerate von Leerstellen noch solche von Silizium-Zwischengitteratomen noch OSF-Defekte (oxidation induced stacking faults) enthält. Solches Material entsteht beispielsweise, wenn der Einkristall gemäß der CZ-Methode gezogen wird und das Verhältnis V/G von Ziehgeschwindigkeit V und axialem Temperaturgradient G an der Kristallisationsgrenze derart kontrolliert wird, dass es zwischen kritischen Grenzen bleibt.

Der Einkristall, von dem die bereitgestellte Substratscheibe aus einkristallinem Silizium geschnitten wird, wird vorzugsweise nicht absichtlich mit Stickstoff oder Kohlenstoff dotiert. Dementsprechend enthält die bereitgestellte Substratscheibe aus einkristallinem Silizium Stickstoff in einer Konzentration von vorzugsweise nicht mehr als 3 x 10¹² Atome/cm³ und Kohlenstoff in einer Konzentration von vorzugsweise nicht mehr als 2,5 x 10¹⁵ Atome/cm³. Die Konzentration an Sauerstoff beträgt in der bereitgestellten Substratscheibe vorzugsweise nicht weniger als 4,5 x 10¹⁷ Atome/cm³ und nicht mehr als 5,5 x 10¹⁷ Atome/cm³, unter Berücksichtigung des Kalibrierungsfaktors gemäß New ASTM.

Die vom Einkristall geschnittene Substratscheibe kann unter Anwendung mechanischer und chemischer Bearbeitungsschritte wie Schleifen und Ätzen weiterverarbeitet werden. Bevorzugt ist es, eine Substratscheibe aus einkristallinem Silizium bereitzustellen, die mindestens einer materialabtragenden Bearbeitung unterzogen wurde, wobei die letzte materialabtragende Behandlung, die bis zum Bereitstellen der Substratscheibe erfolgt, vorzugsweise eine Behandlung mittels Ätzen ist.

Die bereitgestellte und gegebenenfalls epitaktisch beschichtete Substratscheibe aus einkristallinem Silizium wird in einen RTA-Reaktor geladen und im Zuge der ersten RTA-Behandlung vorzugsweise mit einer Rate von nicht weniger als 50 °C/s auf die Zieltemperatur erhitzt.

Im Anschluss an die erste RTA-Behandlung bleibt die bereitgestellte und gegebenenfalls epitaktisch beschichtete Substratscheibe im RTA-Reaktor und wird abgekühlt, vorzugsweise auf eine Temperatur von nicht mehr als 800 °C. Die Abkühlrate beträgt vorzugsweise nicht weniger als 30 °C/s. Gleichzeitig wird die Gaszufuhr in den RTA-Reaktor auf 100 % Argon umgestellt.

Die bereitgestellte und gegebenenfalls epitaktisch beschichtete Substratscheibe aus einkristallinem Silizium wird im Zuge der zweiten RTA-Behandlung vorzugsweise mit einer Rate von nicht weniger als 50 °C/s auf die Zieltemperatur erhitzt.

Der Zeitraum zwischen dem Ende der ersten RTA-Behandlung und dem Beginn der zweiten RTA-Behandlung beträgt vorzugsweise nicht weniger als 25 s und nicht mehr als 50 s.

Die Belastung einer Halbleiterscheibe (gemäß der ersten, zweiten und dritten Ausführungsform) mit Defekten wird vorzugsweise eingedämmt, indem vor der ersten RTA-Behandlung Sauerstoff (100 Vol.-%) durch den RTA-Reaktor geleitet wird, und zwar vorzugsweise mit einer Durchflussgeschwindigkeit von nicht weniger als 8 slm und nicht mehr als 18 slm (Standard Liter pro Minute). Die Defektbelastung der Halbleiterscheibe kann beispielsweise mittels eines hochauflösenden Laser-Streuungssystems untersucht werden. Hier enthaltene Untersuchungsergebnisse wurden teilweise mit Hilfe eines Kanten- und Rückseiteninspektions-Moduls (EBI) von Rudolph Technologies erhalten, das Defekte wie Partikel, Kratzer, Flächendefekte und Haze auf der Rückseite zu bestimmen ermöglicht, teilweise mit einem Inspektionssystem vom Typ Surfscan SP3 des Herstellers KLA Tencor, das LLS-Defekte (localized light scatteres) auf der Vorderseite nachweist.

Die erfindungsgemäße Halbleiterscheibe aus einkristallinem Silizium umfasst einen Bereich mit BMD-Keimen, der sich unter der denuded zone befindet und an die denuded zone angrenzt. BMD-Keime sind Leerstellen umfassende Zentren, an deren Stelle sich nach einer Präzipitations-Wärmebehandlung BMDs entwickeln können. Die Präzipitations-Wärmebehandlung ist nicht Bestandteil eines Verfahrens zur Herstellung einer erfindungsgemäßen Halbleiterscheibe, jedoch notwendig, um zu prüfen, ob sich BMDs entwickeln lassen, die in der geforderten Dichte vorliegen, oder um BMDs zu entwickeln, die ihre Wirkung als Getter-Zentren entfalten. Dementsprechend wird die Präzipitations-Wärmebehandlung entweder testweise oder vorzugsweise im Zuge einer Weiterverarbeitung der Halbleiterscheibe aus einkristallinem Silizium zu elektronischen Bauelementen durchgeführt.

Eine typische Präzipitations-Wärmebehandlung zu Testzwecken besteht aus einer zweistufigen Präzipitations-Wärmebehandlung der erfindungsgemäßen Halbleiterscheibe unter Sauerstoff bei einer Temperatur von 780 °C für eine Dauer von 3 h (1.Stufe, Stabilisierungsschritt) und bei einer Temperatur von 1000 °C für eine Dauer von 16 h (2.Stufe, Wachstumsschritt).

Die Dichte der entwickelten BMDs kann beispielsweise mittels IR-Laserstreulicht-Tomographie als Analysenmethode mit Hilfe eines Nachweisgeräts vom Typ MO-441 der Raytex Corporation, Japan, entlang einer Bruchkante der Halbleiterscheibe bestimmt werden. Zur Auswertung der Messergebnisse, wird typischerweise die mittlere Dichte an BMDs (D_{BMD}) entlang des Radius der Halbleiterscheibe in einem Diagramm aufgetragen (gemittelt über eine Tiefe von 7-300 µm an jeder radialen Messposition, wobei die BMD Defektdichte alle 5 µm in der Tiefenachse gemessen wird), beispielsweise an mindestens 25 radialen Messpositionen P, die denselben Abstand zueinander haben. Darüber hinaus wird an den radialen Messpositionen P der Abstand DZ1 bestimmt, den der erste auftretende BMD zur Vorderseite hat, und dieser Abstand entlang des Radius der Halbleiterscheibe in einem Diagramm aufgetragen. Das arithmetische Mittel der Abstände DZ1 repräsentiert die Tiefe, in die sich die denuded zone von der polierten Vorderseite ins Innere der Halbleiterscheibe erstreckt. Weiterhin kann in einem Diagramm die mittlere Größe sₐᵥ an BMDs (gemittelt über eine Tiefe von 7-300 µm an jeder radialen Messposition, wobei die BMD Defektgröße alle 5 µm in der Tiefenachse gemessen wird) in Abhängigkeit der radialen Messpositionen P aufgetragen werden, sowie der Verlauf der Dichte an BMDs (D_{BMD}) in Tiefenrichtung, also entlang des Abstands d zur Vorderseite der Halbleiterscheibe, bezogen auf eine bestimmte radiale Messposition P.

Die Erfindung wird nachfolgend an Hand von Beispielen und unter Bezugnahme auf Zeichnungen weiter erläutert.

Es wurden Substratscheiben aus einkristallinem Silizium mit einem Durchmesser von 300 mm bereitgestellt. Die Substratscheiben bestanden aus N-Gebiet und hatten Oberflächen in geätztem Zustand. Ein erster Teil der Substratscheiben wurde dem erfindungsgemäßen Verfahren zur Herstellung von Halbleiterscheiben gemäß der ersten bevorzugten Ausführungsform unterzogen.

Vor der ersten RTA-Behandlung wurde Sauerstoff (100 Vol.-%) mit einer Durchflussgeschwindigkeit von 10 slm durch den RTA-Reaktor geleitet. Danach wurde die erste RTA-Behandlung bei einer Temperatur von 1290 °C in einer Atmosphäre von Argon und Sauerstoff (Sauerstoff-Anteil 1 Vol-%) vorgenommen. Die Dauer der ersten RTA-Behandlung bei dieser Temperatur betrug 20 s. Danach wurden die Substratscheiben auf eine Temperatur von 600 °C abgekühlt und über einen Zeitraum von 40 s auf dieser Temperatur gehalten und währenddessen die Gaszufuhr zu den Halbleiterscheiben auf 100 % Argon umgestellt. Danach erfolgte die zweite RTA-Behandlung bei einer Temperatur von 1295 °C und in einer Argon-Atmosphäre über einen Zeitraum von 30 s.

Anschließend wurde die entstandene Oxidschicht von den Substratscheiben entfernt, und die Vorderseiten der Substratscheiben mittels CMP poliert. Die resultierenden Halbleiterscheiben gemäß der ersten Ausführungsform der Erfindung wurden der zu Testzwecken vorgesehenen zweistufigen Präzipitations-Wärmebehandlung unterzogen.

Ein zweiter Teil der Substratscheiben wurde dem Verfahren zur

Herstellung von Halbleiterscheiben gemäß der dritten Ausführungsform unterzogen.

Vor der ersten RTA-Behandlung wurde Sauerstoff (100 Vol.-%) mit einer Durchflussgeschwindigkeit von 10 slm durch den RTA-Reaktor geleitet. Danach wurde die erste RTA-Behandlung bei einer Temperatur von 1290 °C in einer Atmosphäre bestehend aus Stickstoff und Sauerstoff (Sauerstoff-Anteil 1 Vol-%) vorgenommen. Die Dauer der ersten RTA-Behandlung bei dieser Temperatur betrug 20 s. Danach wurden die Substratscheiben auf eine Temperatur von 600 °C abgekühlt und über einen Zeitraum von 40 s auf dieser Temperatur gehalten und währenddessen die Gaszufuhr zu den Halbleiterscheiben auf 100 % Argon umgestellt.

Danach erfolgte die zweite RTA-Behandlung bei einer Temperatur von 1295 °C und in einer Argon-Atmosphäre über einen Zeitraum von 30 s.

Anschließend wurden die Substratscheiben zunächst mittels DSP und dann mittels CMP poliert, und die resultierenden Halbleiterscheiben gemäß der dritten Ausführungsform ebenfalls der zu Testzwecken vorgesehenen zweistufigen Präzipitations-Wärmebehandlung unterzogen.

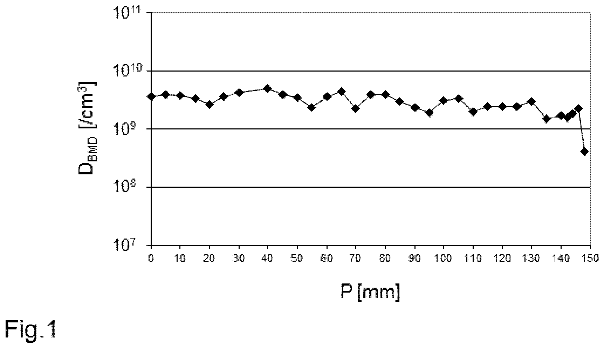

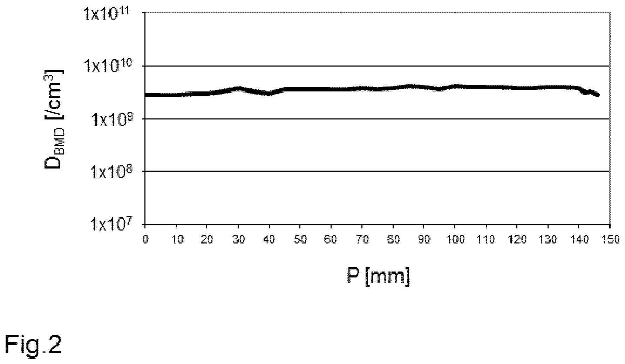

Fig.1 und Fig.2 zeigen jeweils den radialen Verlauf der mittleren Dichte D_{BMB} an BMDs am Beispiel von Repräsentanten von Halbleiterscheiben der ersten Ausführungsform (Fig.1) und der dritten Ausführungsform (Fig.2).

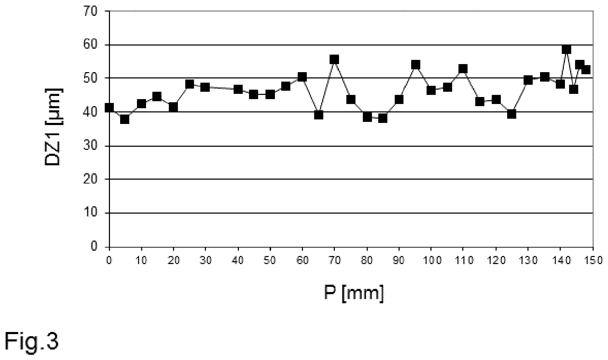

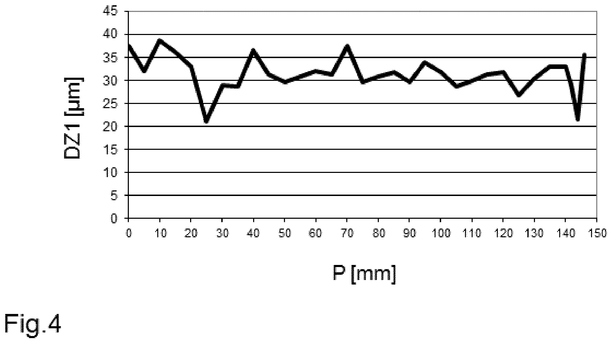

Fig.3 und Fig.4 zeigen jeweils den radialen Verlauf des Abstands DZ1 am Beispiel von Repräsentanten von Halbleiterscheiben der ersten Ausführungsform (Fig.3) und der dritten Ausführungsform (Fig.4), mit einer entsprechenden Tiefe der denuded zone von nicht weniger als 45 µm (Fig.3) beziehungsweise von nicht weniger als 30 µm (Fig.4).

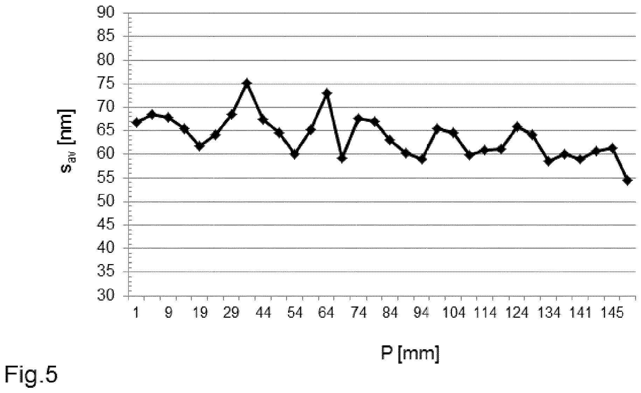

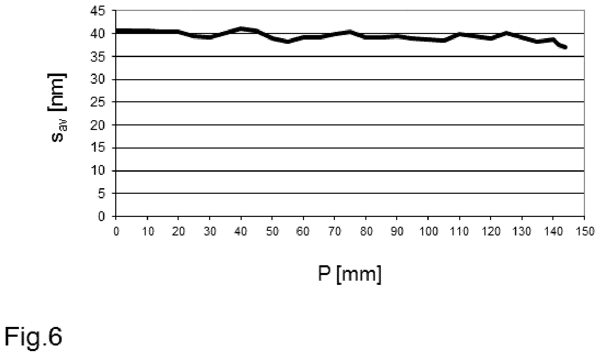

Fig.5 und Fig.6 zeigen am Beispiel von Repräsentanten von Halbleiterscheiben der ersten Ausführungsform (Fig.5) und der dritten Ausführungsform (Fig.6) jeweils die mittlere Größe sₐᵥ der BMDs in Abhängigkeit von deren radialer Position.

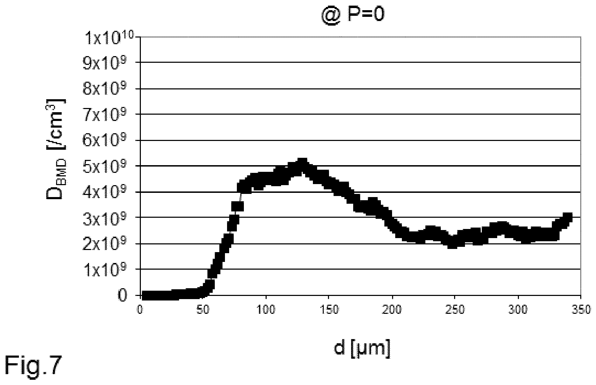

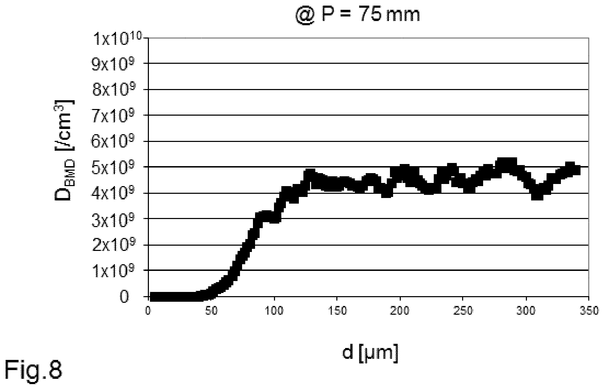

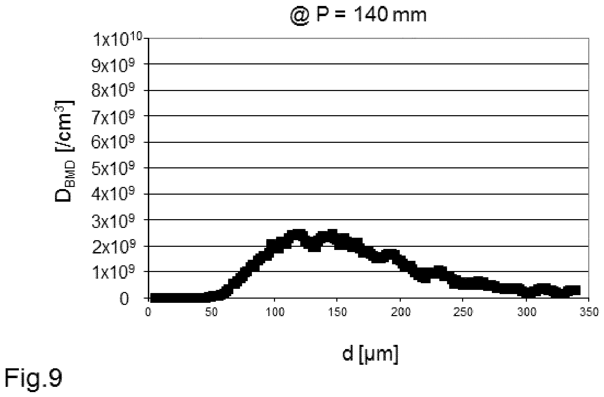

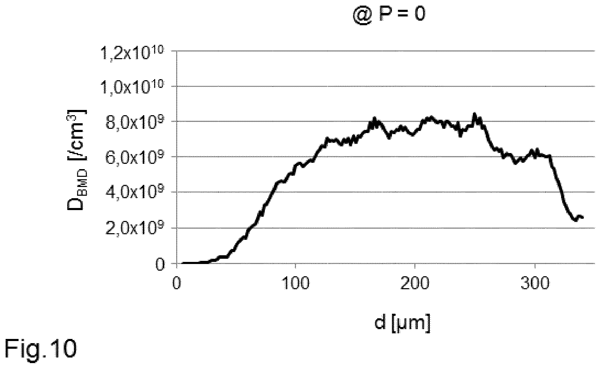

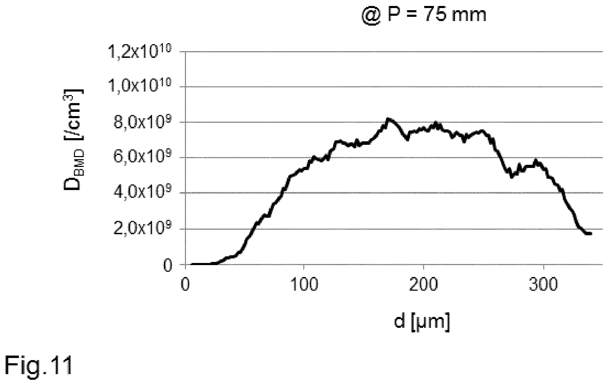

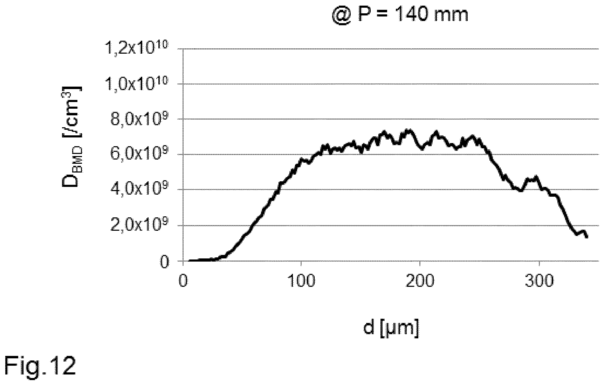

Fig.7 bis Fig.12 zeigen jeweils ein Tiefenprofil der Dichte D_{BMD} an BMDs am Beispiel von Repräsentanten von Halbleiterscheiben der ersten Ausführungsform (Fig.7, Fig.8 und Fig.9) und der dritten Ausführungsform (Fig.10, Fig.11 und Fig.12), wobei das Tiefenprofil im Zentrum (P = 0 mm; Fig.7 und Fig.10), bei halbem Radius (P = 75 mm; Fig.8 und Fig.11) und im radialen Abstand P = 140 mm (Fig.9 und Fig.12) bestimmt wurde.

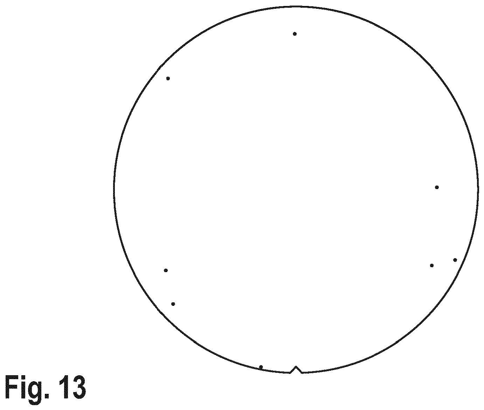

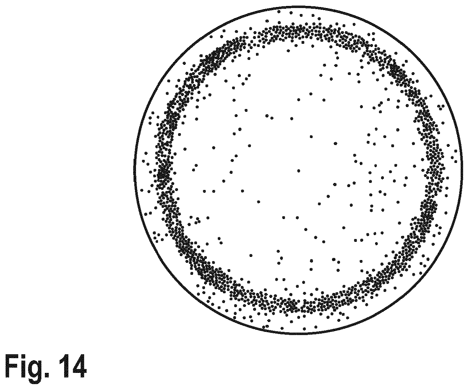

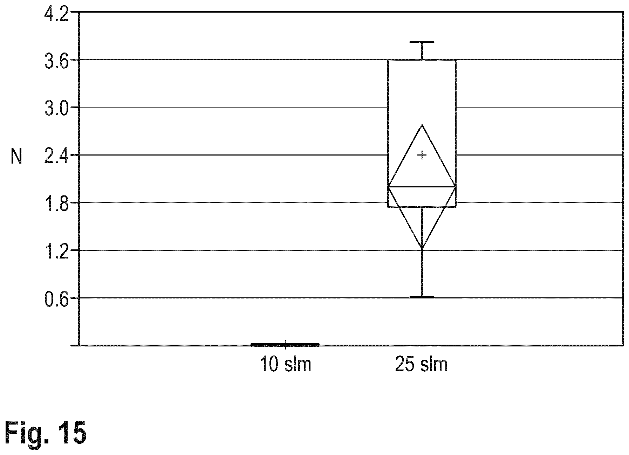

Fig.13 und Fig.14 zeigen Untersuchungsergebnisse, die nach einer Untersuchung der Rückseiten von Repräsentanten der Halbleiterscheiben mit dem erwähnten Kanten- und Rückseiteninspektions-Modul (EBI) erhalten wurden. Fig.13 zeigt eine typische Defektbelastung der Rückseite einer erfindungsgemäßen Halbleiterscheibe von 8 Defekten größer als 0.2 µm und damit weniger als 100 Defekten, wobei bei der Herstellung der Halbleiterscheibe darauf geachtet wurde, dass vor der ersten RTA-Behandlung reiner Sauerstoff durch den RTA-Reaktor mit einer Durchflussgeschwindigkeit von 10 slm geleitet wurde. Wird auf das Durchleiten von Sauerstoff verzichtet, ist die Defektbelastung der Rückseite deutlich größer und es können ringförmige Defektbereiche mit hohen Defektdichten (Fig.14) beobachtet werden(wiederum wurden alle Defekte größer als 0,2 µm gemessen und dargestellt). Andererseits ist es nicht vorteilhaft, die Durchflussgeschwindigkeit des Sauerstoffs vor der ersten RTA-Behandlung auf Werte von beispielsweise 25 slm einzustellen. In diesem Fall ist die Anzahl von LLS-Defekten mit einem Latexkugel-Äquivalent von ≥ 0,13 µm unakzeptabel hoch. Das ist nicht der Fall, sofern die Durchflussgeschwindigkeit des Sauerstoffs im Bereich von nicht weniger als 8 slm und nicht mehr als 18 slm ausgewählt wird. Fig.15 zeigt diesen Unterschied an Hand einer Kastengrafik (boxwhisker-plot), wobei die Anzahl N an LLS-Defekten normalisiert wurde. Es ist generell vorteilhaft den Oxidationszustand des RTA-Reaktors in regelmäßigen Abständen durch Fahrten in Gegenwart von Platzhalterscheiben (wafer dummies) neu zu konditionieren. Dieses findet vorzugsweise in einem Ambient von Ar/O₂ mit einem O₂ Vol% Anteil 75-100% und einem Fluss von 20-25 slm statt.

## Patentansprüche

1. Halbleiterscheibe aus einkristallinem Silizium umfassend eine polierte Vorderseite und eine Rückseite;
eine denuded zone, die sich von der polierten Vorderseite zur Rückseite bis in eine Tiefe von nicht weniger als 45 µm erstreckt; und
einen Bereich, der an die denuded zone angrenzt und BMD-Keime aufweist, die sich zu BMDs entwickeln lassen, wobei eine Dichte der BMDs im Abstand von 120 µm zur Vorderseite nicht weniger als 3 x 10⁹ cm⁻³ beträgt.

2. Halbleiterscheibe nach Anspruch 1, umfassend eine epitaktische Schicht aus einkristallinem Silizium, wobei eine obere Oberfläche der epitaktischen Schicht die Vorderseite der Halbleiterscheibe bildet, wodurch die Tiefe, in die sich die denuded zone erstreckt, um den Betrag der Dicke der epitaktischen Schicht erhöht ist.

3. Halbleiterscheibe nach Anspruch 1 oder Anspruch 2, wobei die Rückseite der Halbleiterscheibe mit nicht mehr als 100 Defekten größer als 0,2 µm belastet ist.

## Claims

1. A single crystal silicon semiconductor wafer comprising a polished front surface and a back surface;
a denuded zone extending from the polished front surface to the back surface to a depth of not less than 45 µm; and
a region adjacent to the denuded zone and having BMD nuclei capable of developing into BMDs, wherein a density of the BMDs at a distance of 120 µm from the front surface is not less than 3 x 10⁹ cm⁻³.

2. The semiconductor wafer of claim 1, comprising
an epitaxial layer of single crystal silicon, wherein an upper surface of the epitaxial layer forms the front surface of the semiconductor wafer, whereby the depth to which the denuded region extends is increased by the amount of the thickness of the epitaxial layer.

3. The semiconductor wafer of claim 1 or claim 2, wherein the backside of the semiconductor wafer is loaded with no more than 100 defects greater than 0.2 µm.

## Revendications

1. Tranche de semi-conducteur en silicium monocristallin comprenant une surface avant polie et une surface arrière ;
une zone dénudée s'étendant de la surface avant polie à la surface arrière jusqu'à une profondeur non inférieure à 45 µm ; et
une région adjacente à la zone dénudée et ayant des noyaux de BMD capables de se développer en BMD, dans laquelle une densité des BMD à une distance de 120 µm de la surface avant n'est pas inférieure à 3 x 10⁹ cm⁻³.

2. Plaquette semi-conductrice selon la revendication 1, comprenant une couche épitaxiale de silicium
monocristallin, dans laquelle une surface supérieure de la couche épitaxiale forme la surface avant de la plaquette semi-conductrice, de sorte que la profondeur à laquelle la zone dénudée s'étend est augmentée de la quantité de l'épaisseur de la couche épitaxiale.

3. Plaquette semi-conductrice selon la revendication 1 ou la revendication 2, dans laquelle la face arrière de la plaquette semi-conductrice est chargée de pas plus de 100 défauts supérieurs à 0,2 µm.
